# EUROPÄISCHE PATENTSCHRIFT

(11) **EP 3 673 291 B1**
(45) Veröffentlichungstag und Bekanntmachung des Hinweises auf die Patenterteilung: **14.02.2024**
(21) Anmeldenummer: 18759545.9
(22) Anmeldetag: 02.08.2018
(51) Int. Cl.: G01S 7/481, H01S 5/00, B81B 7/00, G01S 17/42, G02B 26/08, G02B 26/12, H01S 5/40, H01S 5/02255

(54) **SENDEEINRICHTUNG MIT EINEM DURCH EIN KOLLIMIERENDES ABDECKELEMENT ÜBERDECKTEN SCANSPIEGEL**
TRANSMITTER DEVICE WITH A SCANNING MIRROR COVERED BY A COLLIMATING COVERING ELEMENT
DISPOSITIF D'ÉMISSION COMPRENANT UN MIROIR DE BALAYAGE RECOUVERT PAR UN ÉLÉMENT DE RECOUVREMENT DE COLLIMATION

(30) Priorität: 21.08.2017 DE 202017105001 U; 13.10.2017 DE 102017123878
(43) Veröffentlichungstag der Anmeldung: 01.07.2020
(73) Patentinhaber: JENOPTIK Optical Systems GmbH, 07745 Jena (DE)
(72) Erfinder: SCHALLER, Uwe, 07768 Kahla (DE); RAABE, Christian, 07743 Jena (DE)
(74) Vertreter: Gleim Petri Patent- und Rechtsanwaltspartnerschaft mbB
(86) Internationale Anmeldenummer: PCT/DE2018/100682
(87) Internationale Veröffentlichungsnummer: WO 2019/037810

(56) Entgegenhaltungen:
- CN-A- 102 914 872
- DE-A1-102011 006 159
- DE-A1-102012 025 281
- DE-A1-102015 110 141
- US-B1- 6 771 686
- US-B1- 9 086 273
- KOTA ITO ET AL: "System Design and Performance Characterization of a MEMS-Based Laser Scanning Time-of-Flight Sensor Based on a 256 $\times$ 64-pixel Single-Photon Imager", IEEE PHOTONICS JOURNAL, IEEE, USA, Bd. 5, Nr. 2, 1. April 2013 (2013-04-01), Seite 6800114, XP011510713, ISSN: 1943-0655, DOI: 10.1109/JPHOT.2013.2247586
- YANG B ET AL: "A compact MEMS-based wide-angle optical scanner", 2017 INTERNATIONAL CONFERENCE ON OPTICAL MEMS AND NANOPHOTONICS (OMN), IEEE, 13. August 2017 (2017-08-13), Seiten 1-2, XP033157511, DOI: 10.1109/OMN.2017.8051503 ISBN: 978-1-5386-0735-0 [gefunden am 2017-09-26]
- SIEPMANN J P ET AL: "Integrable Ultra-Compact, High-Resolution, Real-Time MEMS Ladar for the Individual Soldier", MILITARY COMMUNICATIONS CONFERENCE, 2005. MILCOM 2005. IEEE ATLANTIC CITY, NJ, USA 17-20 OCT. 2005, PISCATAWAY, NJ, USA,IEEE, PISCATAWAY, NJ, USA, 17. Oktober 2005 (2005-10-17), Seiten 1-7, XP010901686, DOI: 10.1109/MILCOM.2005.1606131 ISBN: 978-0-7803-9393-6

## Beschreibung

Die Erfindung betrifft eine Sendeeinrichtung für einen LIDAR-Scanner, der mit kollimierter Laserstrahlung wenigstens einen Scanwinkelbereich abscannt.

Bei der Entfernungsmessung, bei der einzelne Scanpunkte quasi ins Unendliche abgebildet werden, weisen die einzelnen Scanwinkelbereiche durch das Scannen eines zweidimensionalen Scanfeldes eine dreidimensionale oder durch das Scannen einer eindimensionalen Scanlinie eine zweidimensionale Ausdehnung auf.

Während die Ausdehnung des Scanfeldes bzw. der Scanlinie durch den maximalen Auslenkwinkel des Scanspiegels begrenzt sind, ist dessen Tiefe grundsätzlich zum einen durch das Lambert-Beersche Gesetz, nach dem die Intensität der Strahlung mit dem Laufweg exponentiell abnimmt, bestimmt und durch die geforderte Laserklasse, die die Leistung der Strahlungsquelle begrenzt.

Große Scanwinkelbereiche sind z.B. dort von Interesse, wo ein großer Bereich im Raum lückenlos überwacht werden soll. Einsatzgebiete hierfür können z.B. das Flugwesen, die Schifffahrt, die Militärtechnik oder das autonome Fahren von Straßenfahrzeugen sein.

Mit der Verwendung eines rotierenden Spiegels als Scanspiegel, mit dem große Scanwinkel überstrichen werden können, bedarf es weiterer diskreter Bauteile wie z.B. Halterungen, in denen die Spiegelachse gelagert ist. Die mit der Rotation entstehende Reibung führt zu Verschleiß und dadurch verursachtem Schlupf. Auch sind Baugruppen aus diskreten Bauteilen heutzutage in der Regel aufwendiger in der Herstellung und damit teurer als monolithisch hergestellte Baugruppen. Sie lassen sich auch weniger leicht miniaturisieren und sind in der Regel schwerer.

Völlig verschleißfrei arbeiten MEMS-Spiegel (Mikro-elektromechanisches System), die monolitisch über Festkörpergelenke mit einem Rahmen verbunden sind, wobei zwei um den Mittelpunkt des MEMS-Spiegels um 180° zueinander versetzt angeordnete Festkörpergelenke mechanisch betrachtet eine Drehachse bilden. Es gibt handelsübliche MEMS-Spiegel, die nur um eine Drehachse, die um zwei zueinander senkrechte Drehachsen oder auch um drei oder mehr Gelenke, die einzelne Aufhängungen bilden, ausgelenkt werden können. Der Auslenkwinkel des MEMS-Spiegels gegenüber dem Rahmen ist dabei aufgrund der Festkörpergelenkverbindung jeweils auf ca. +/-10° um eine unausgelenkte Nullstellung begrenzt. Der reibungsfreie Betrieb, seine hohe erreichbare Betriebsfrequenz und der inzwischen vergleichsweise geringe Preis machen MEMS-Spiegel gerade für dynamische kompakte und robuste Geräte sehr attraktiv.

Bei einer Verwendung von MEMS-Spiegeln als Scanspiegel für eine Sendeeinrichtung eines LIDAR-Scanners ist jedoch der begrenzte, kleine Auslenkwinkel von Nachteil. Der maximale Scanwinkelbereich für einen über den MEMS-Spiegel reflektierten Laserstrahl ergibt sich aus dem Vierfachen des maximalen Auslenkwinkels und beträgt somit maximal ca. 40°. Es läge auf der Hand mehrere MEMS-Spiegel zu verwenden, um aus den Scanwinkelbereichen der einzelnen MEMS-Spiegel einen zusammengesetzten größeren Scanwinkelbereich zu erzielen oder um mehrere Scanwinkelbereiche zu schaffen, die voneinander entfernt beabstandet liegen. Dadurch würde jedoch zum einen die Kompaktheit der Vorrichtung leiden und zum anderen müssten technische Maßnahmen getroffen werden, um die MEMS-Spiegel in ihrem Bewegungsablauf zu synchronisieren. Stattdessen mehrere Laserstrahlen unter unterschiedlichen Auftreffwinkel auf einen MEMS-Spiegel zu richten, sodass diese mehrere aneinandergrenzende einzelne Scanwinkelbereiche abscannen die sich zu einem großen Scanwinkelbereich zusammenfügen, hätte den Nachteil, dass ein dem MEMS-Spiegel vorgeordnetes Abdeckelement, welches gemäß dem Stand der Technik nur in Form einer Planplatte bekannt ist, die einzelnen Laserstrahlen unterschiedlich beeinflusst. Außerdem bedürfte es pro Laserstrahl einer Laserstrahlquelle mit jeweils einem in Abstrahlrichtung nachgeordneten Kollimator, wobei die Laserstrahlquellen in ihrer Abstrahlrichtung so zueinander ausgerichtet werden müssen, dass sie unter bestimmten unterschiedlichen Auftreffwinkeln auf den MEMS-Spiegel auftreffen.

Unabhängig davon ob es sich bei dem Scanspiegel um einen MEMS-Spiegel handelt, kann es Gründe geben, dass der Scanspiegel, in einem Gehäuse eingehaust und von einem Abdeckelement überdeckt und somit geschützt ist. Bei dem Abdeckelement handelt es sich hierbei, soweit bekannt, immer um eine zum unausgelenkten Spiegel parallel oder geneigt angeordnete transparente Planplatte.

Ein auf das Abdeckelement auftreffender Laserstrahl, das betrifft gegebenenfalls auch mehrere Laserstrahlen, die auf den Scanspiegel gerichtet werden, und jeden der Laserstrahlen nach der Reflexion am Scanspiegel, erfährt folglich in Abhängigkeit vom Auftreffwinkel auf die Planplatte mehr oder weniger Fresnelsche Verluste, die die Intensität des Laserstrahls ortsabhängig mehr oder weniger verringern. Darüber hinaus kann es zu unerwünschten Reflexen am Abdeckelement kommen.

Aus der DE 10 2012 025 281 A1 ist eine optische Objekterfassungseinheit mit einer Sendeeinheit bekannt, die einen Sender zum Ausstrahlen eines Laserstrahls, einen um seinen Mittelpunkt um eine oder zwei Schwenkrichtungen schwenkbaren Mikrospiegel und eine Sendelinse, die dem Mikrospiegel im Sendestrahlengang, diesen überdeckend, nachgeordnet ist, enthält. Die Sendelinse, ausgeführt als eine Meniskuslinse, kann hier auch als Abdeckung eines Gehäuses der Sendeeinheit fungieren. Nachteilig ist hier, dass der Mikrospiegel nicht für sich allein eingehaust werden kann, da der Laserstrahl zum Mikrospiegel hin nicht über die Sendelinse geführt werden kann.

Aus der DE 10 2011 006 159 A1 ist eine Projektionsvorrichtung mit einem zumindest in zwei Schaltpositionen schwenkbaren MEMS-Spiegel, der von einer Gradientenindexlinse abgedeckt wird, bekannt. Die Gradientenindexlinse ist eine stark positiv brechende Plankonvexlinse bzw. ein stark positiv brechender Meniskus, deren bzw. dessen Planfläche bzw. konkave Fläche dem MEMS-Spiegel zugewandt angeordnet ist. Ein über die Gradientenindexlinse einfallendes, vermutlich paralleles Laserstrahlenbündel wird auf den MEMS-Spiegel fokussiert und nach Reflexion bei erneutem Durchtritt durch die Gradientenindexlinse gegebenenfalls wieder kollimiert. Nachteilig ist zum einen, dass der MEMS-Spiegel, begrenzt durch die Planfläche der Gradientenindexlinse, nur einen sehr kleinen Schwenkbereich aufweist, und zum anderen, dass gegebenenfalls aus unterschiedlichen Auftreffwinkeln kommende Laserstrahlen aufgrund der Brechung an der Planfläche bzw. der konkaven Fläche der Gradientenindexlinse nicht in einem gleichen Punkt auf dem MEMS-Spiegel auftreffen.

Es ist die Aufgabe der Erfindung eine Sendeeinrichtung, mit einem durch ein Abdeckelement geschützten Scanspiegel für einen LIDAR-Scanner zu finden, wobei an dem Abdeckelement höchstens geringe Fresnelsche Verluste und keine unerwünschten Reflexe auftreten. Darüber hinaus soll die Sendeeinrichtung eine kompakte Bauform aufweisen und in der Herstellung justagearm sein.

Die Aufgabe der Erfindung wird mit den Merkmalen des Anspruches 1 gelöst. Vorteilhafte Ausführungen sind in den rückbezogenen Unteransprüchen angegeben. Die Erfindung soll nachfolgend anhand von Ausführungsbeispielen und Zeichnungen näher erläutert werden.

Hierzu zeigen:
- Fig. 1a - 1c: Prinzipskizzen für ein erstes Ausführungsbeispiel für eine erfindungsgemäße Sendeeinrichtung,
- Fig. 2a - 2b: Prinzipskizzen für ein zweites Ausführungsbeispiel für eine Sendeeinrichtung,
- Fig. 3a - 3b: Prinzipskizzen für ein drittes Ausführungsbeispiel für eine Sendeeinrichtung,
- Fig. 4: eine Ausgestaltung des zweiten Ausführungsbeispiels für eine Sendeeinrichtung in perspektivischer Darstellung und
- Fig. 5: eine Ausgestaltung des dritten Ausführungsbeispiels für eine Sendeeinrichtung in perspektivischer Darstellung.

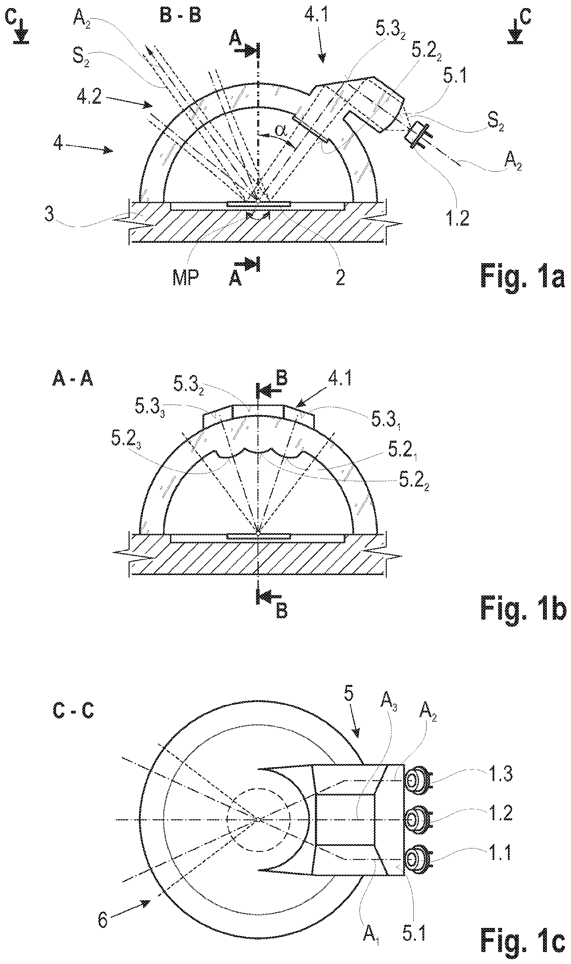

Ein erfindungsgemäße Sendeeinrichtung enthält in allen Ausführungsformen, wie beispielsweise aus den **Fig. 1a bis 1c** zu entnehmen, entweder eine einzelne Laserdiode 1.1 oder wenigstens zwei Laserdioden 1.1, ..., 1.n, die jeweils einen Laserstrahl S₁, ..., Sₙ mit einer Strahlachse A₁, ..., Aₙ und mit unterschiedlichen Abstrahlwinkeln in einer fast axis fa und einer slow axis sa abstrahlen.

Im Falle, dass die Sendeeinrichtung wenigstens zwei Laserdioden 1.1, ..., 1.n enthält sind diese in Richtung ihrer slow axis sa nebeneinander, eine Reihe bildend angeordnet und die Strahlachsen A₁, ..., Aₙ verlaufen zueinander parallel. Sei können dadurch im Vergleich zu einer Anordnung bei der die Strahlachsen einen Winkel miteinander einschließen enger zueinander angeordnet werden und es bedarf keiner Justage zur Einstellung der Winkellage.

Darüber hinaus enthält die Sendeeinrichtung erfindungsgemäß einen um seinen Mittelpunkt MP auslenkbaren Scanspiegel 2, der innerhalb eines Gehäuses 3 mit einem transparenten Abdeckelement 4 angeordnet ist. Die Strahlachse A₁, ..., Aₙ des wenigstens einen Laserstrahls S₁, ..., Sₙ ist so auf das Abdeckelement 4 gerichtet, dass sie nach Durchtritt des wenigstens einen Laserstrahls S₁, ..., Sₙ, durch das Abdeckelement 4 innerhalb eines Einkoppelbereiches 4.1, auf dem Mittelpunkt MP auftrifft, und dass der wenigstens eine Laserstrahl S₁, ..., Sₙ nach Reflexion am Scanspiegel 2 das Abdeckelement 4.2 erneut, innerhalb eines Auskoppelbereiches 4.2, durchtritt.

Es ist erfindungswesentlich, dass das Abdeckelement 4 im Einkoppelbereich 4.1 eine toroidale Eintrittsfläche 5.1, zur Vorkollimierung des wenigstens einen Laserstrahls S₁, ..., Sₙ in Richtung der fast axis fa, den wenigstens zwei Laserdioden 1.1, ..., 1.n zugeordnet jeweils eine erste Spiegelfläche 5.3₁, ..., 5.3ₙ, zur Umlenkung der Laserstrahlen S₁, ..., Sₙ auf den Mittelpunkt MP, und wenigstens eine toroidale Austrittsfläche 5.2₁, ..., 5.2ₙ, zur Vorkollimierung des wenigstens einen Laserstrahls S₁, ..., Sₙ in Richtung der slow axis sa, aufweist. Unter einer toroidalen Fläche (toroidal surface) wird die Oberfläche oder ein Ausschnitt der Oberfläche eines Körpers verstanden, der geometrisch durch die Rotation einer ebenen Figur um eine Rotationsachse, welche in derselben Ebene wie die Figur selbst liegt, erzeugt werden kann. Ein solcher Körper wird auch als Toroid bezeichnet werden. Wichtige Sonderfälle oder Grenzfälle eines Toroids sind Torus, Kugel und Kreiszylinder sowie auch zylindrische Körper mit beliebigem (insbesondere auch parabolischem) Querschnitt. Oberflächen und Auschnitte von Oberflächen solcher Sonder- oder Grenzfälle werden deshalb ebenfalls als Beispiele toroidaler Flächen angesehen. Es ist dem Fachmann geläufig die Fläche zur Korrektur von Bildfehlern leicht abzuwandeln.

Eine toroidale (brechende oder reflektierende) optische Fläche beeinflusst im Allgemeinen die Strahlform in zwei zueinander senkrechten Richtungen unterschiedlich. Im Sonder- oder Grenzfall einer zylindrischen Linse (deren Querschnittsform dabei nicht sphärisch zu sein braucht) bleibt die Strahlform in einer Richtung unbeeinflusst. Im Sonder- oder Grenzfall einer gewöhnlichen sphärischen Linse wird sie in beiden Richtungen gleichermaßen beeinflusst.

Es ist des Weiteren erfindungswesentlich, dass das Abdeckelement 4 wenigstens im Auskoppelbereich 4.2 durch einen Ausschnitt einer monozentrischen Halbkugelschale HK gebildet ist und das Abdeckelement 4 so den Scanspiegel 2 überdeckend angeordnet ist, dass der Krümmungsmittelpunkt K der gedachten monozentrischen Halbkugelschale HK (nachfolgend nur Halbkugelschale HK) und der Mittelpunkt MP des Scanspiegels 2 zusammenfallen. Monozentrisch heißt die Krümmungsmittelpunkte der beiden Oberflächen der Halbkugelschale HK fallen zusammen. Fertigungs- und montagebedingte Toleranzen, Langzeitdriften sowie Toleranzabweichungen zwischen der Lage des Krümmungsmittelpunktes K und dem Mittelpunkt MP führen zu einer sich verschlechternden Strahlqualität, sind aber in Grenzen tolerierbar.

Völlig unabhängig von einem Auftreffwinkel α₁, ..., αₙ, unter dem der wenigstens eine Laserstrahl S₁,..., Sₙ gegenüber dem Lot L des unausgelenkten Scanspiegels 4 auf den Scanspiegel 4 auftrifft, trifft dessen Strahlachse A₁, ..., Aₙ nach der Reflexion am Scanspiegel 4, unabhängig von seiner Position während der Auslenkung des Scanspiegels 2, immer lotrecht auf den im Auskoppelbereich 4.2 gebildeten Ausschnitt der Halbkugelschale HK auf.

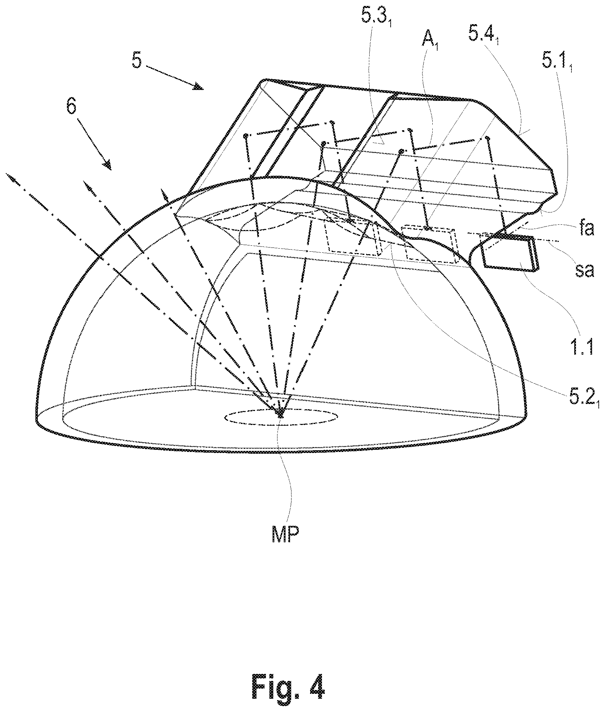

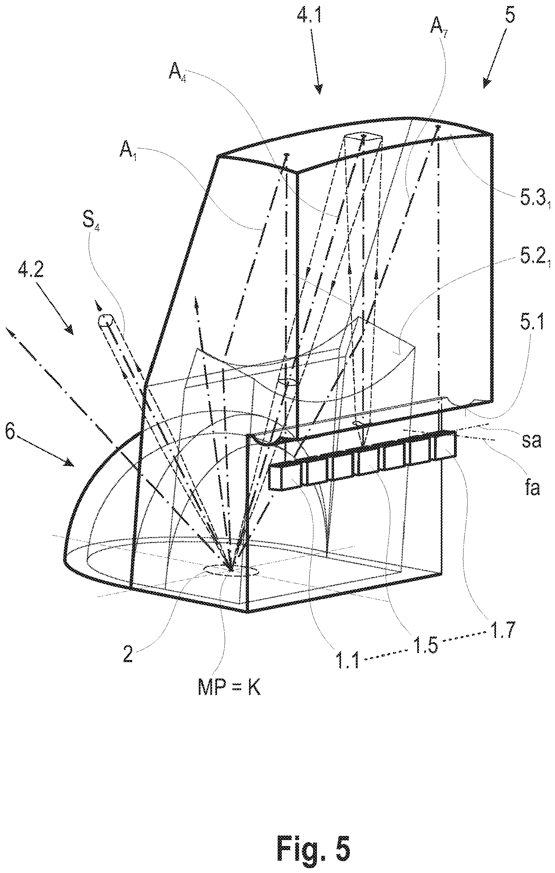

Die auf das Abdeckelement auftreffenden Laserstrahlen S₁, ..., Sₙ werden erfindungsgemäß beim Durchtritt des Abdeckelementes 4 innerhalb des Einkoppelbereiches 4.1 zum einen umgelenkt und zum Anderen in Richtung der fast axis fa und der slow axis sa der Laserdioden 1.1, ..., 1.n so vorkollimiert, dass sie unter einem gleichen kleinen Konvergenzwinkel in Richtung der fast axis fa und der slow axis sa auf den Mittelpunkt MP des Scanspiegels 2 auftreffen und nach Durchtritt des Abdeckelementes 4 innerhalb des Auskoppelbereiches 4.2 vollständig kollimiert sind. Vorteilhaft wird das Abdeckelement 4 durch eine Schale 6 und einen, wie in Fig. 4 gezeigt, in diesen integrierten optischen Block 5 gebildet. Das Abdeckelement 4 kann ebenfalls vorteilhaft durch eine Schale 6 und einen daran angrenzenden optischen Block 5 gebildet sein, wie in **Fig. 5** dargestellt. Dabei sind an der Schale 6 der Ausschnitt der Halbkugelschale HK und an dem optischen Block 5 die toroidale Eintrittsfläche 5.1, die wenigstens zwei ersten Spiegelflächen 5.3₁, ..., 5.3ₙ und die wenigstens eine toroidale Austrittsfläche 5.2₁, ..., 5.2ₙ ausgebildet.

Die Schale 6 stellt vorteilhaft einen Teil der Halbkugelschale HK dar.

In den **Fig. 1a bis 1c** ist eine erstes Ausführungsbeispiel mit beispielhaft drei Laserdioden 1.1, 1.2, 1.3, einschließlich dem von der Laserdiode 1.2 ausgehenden Laserstrahl S₂, sowie den Strahlachsen A₁, A₂, A₃ der Laserdioden 1.1, 1.2, 1.3 dargestellt. Die Laserstrahlen S₁, S₂, S₃ werden durch Brechung an der toroidalen Eintrittsfläche 5.1₁ in Richtung der fast axis fa vorkollimiert. Die toroidale Eintrittsfläche 5.1₁ stellt hier eine Zylinderfläche dar.

Es ist eine gleiche Anzahl von ersten Spiegelflächen 5.3₁, 5.3₂, 5.3₃ vorhanden, wie Laserstrahlen S₁, S₂, S₃ vorhanden sind. Die ersten Spiegelflächen 5.3₁, 5.3₂, 5.3₃ sind zueinander geneigte Planflächen, wobei sich deren Größe und der Abstand ihrer Mittelpunkte sowie der Neigungswinkel zwischen den benachbarten Planflächen jeweils aus dem Abstand der Laserdioden 1.1, 1.2, 1.3 ergibt. Während der mittlere der drei Laserstrahlen S₂ nur in einer Ebene umgelenkt wird, in der die fast axis fa liegt, werden die äußeren Laserstrahlen S₁, S₃ auch in der hierzu senkrechten Ebene umgelenkt, so dass alle drei Laserstrahlen S₁, S₂, S₃ auf den Mittelpunkt MP des Scanspiegels 2 auftreffen. Die ersten Spiegelflächen 5.3₁, 5.3₂, 5.3₃ haben dabei keinen Einfluss auf die Kollimation der Laserstrahlen S₁, S₂, S₃. Jedem der ersten Spiegelflächen 5.3₁, 5.3₂, 5.3₃ ist eine toroidale Austrittsfläche 5.2₁, 5.2₂, 5.2₃ zugeordnet. Die toroidalen Austrittsflächen 5.2₁, 5.2₂, 5.2₃ können jeweils eine Zylinderfläche sein und folglich nur in Richtung der slow axis sa kollimieren, sind aber bevorzugt toroidale Fächen, die in der slow axis sa und zusätzlich in der fast axis fa kollimieren, sodass die Eintrittsfläche 5.1 eine geringere Brechkraft aufweisen kann. Vorteilhaft können hierfür sphärische Flächen vorgesehen werden, wenn durch die Vorkollimation der Laserstrahlen S₁, S₂, S₃ an der toroidalen Eintrittsfläche 5.1 der Strahlwinkel der Laserstrahlen S₁, S₂, S₃ in Richtung der fast axis fa bereits an den Strahlwinkel in Richtung der slow axis sa angepasst wurde. Die vorkollimierten Laserstrahlen S₁, S₂, S₃ müssen leicht konvergent sein, um dann durch die Brechung im Auskoppelbereich 4.2, der eine negative Brechkraft hat, erfindungsgemäß vollständig kollimiert zu werden.

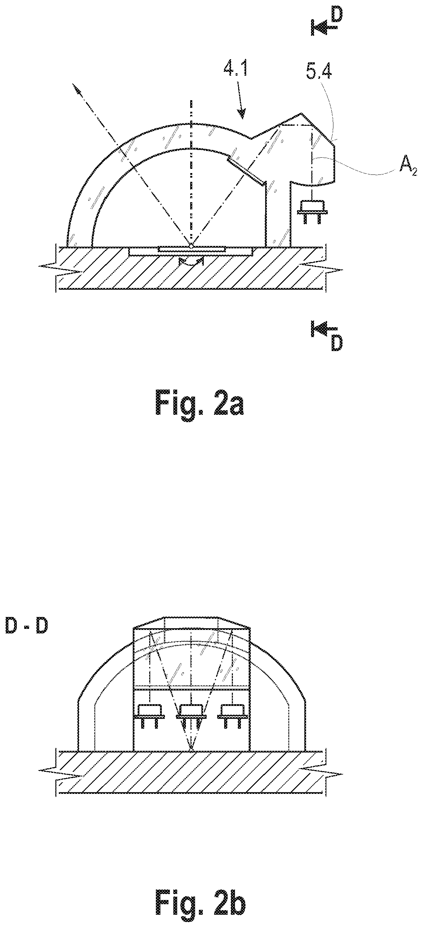

Das in **Fig. 2a** und **Fig. 2b** dargestellte zweite Ausführungsbeispiel unterscheidet sich zu dem ersten Ausführungsbeispiel dadurch, dass im Einkoppelbereich 4.1 eine zweite Spiegelfläche 5.4 vorhanden ist. Die zweite Spiegelfläche 5.4 dient lediglich der Faltung der Laserstrahlen S₁, S₂, S₃, um den Raumbedarf zu minimieren und die Lage der Eintrittsfläche 5.1 und der Laserdioden 1.1, 1.2, 1.3 variieren zu können.

In **Fig. 4** ist eine perspektivische Darstellung einer Ausgestaltung des zweiten Ausführungsbeispiels gezeigt. Hier ist deutlich zu erkennen, dass die Form des Abdeckelementes 4 außerhalb des Einkoppel- und des Auskoppelbereiches 4.1, 4.2 für eine Minimierung des Raumbedarfes angepasst wurde.

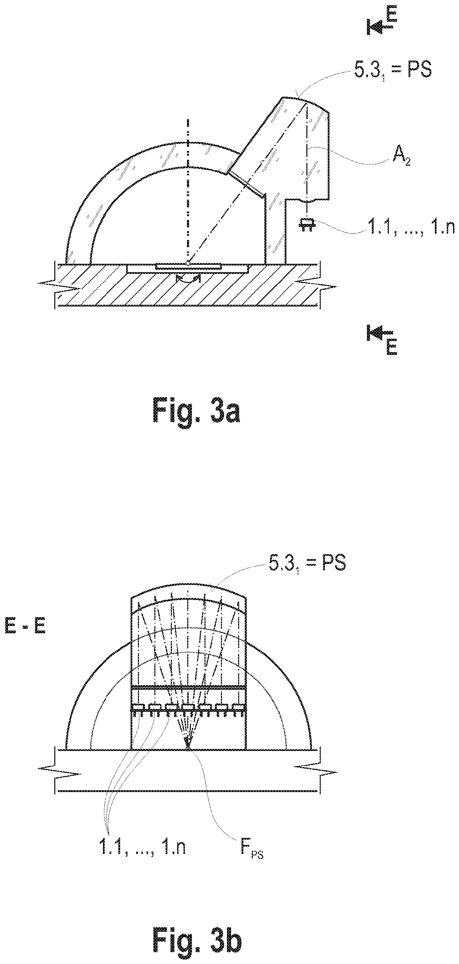

Das in **Fig. 3a und 3b** gezeigte dritte Ausführungsbeispiel ist besonders vorteilhaft, für eine größere Anzahl von Laserdioden 1.1, ...., 1.n oder für den Fall, dass die Abstände der Strahlachsen A₁, ..., Aₙ vorgegeben sind. Anstelle einer gleichen Anzahl von ersten Spiegelflächen 5.3₁, ..., 5.3ₙ wie Laserdioden 1.1, ..., 1.n vorhanden sind, gibt es hier nur eine erste Spiegelfläche 5.3₁, die eine parabolische Spiegelfläche PS mit einem Brennpunkt F_{PS} ist und so angeordnet ist, dass der Brennpunkt F_{PS}, bei einer theoretischen Vernachlässigung der Brechkraft der hier einen nachgeordneten toroidale Austrittsfläche 5.2₁, mit dem Krümmungsmittelpunkt K und dem Mittelpunkt MP zusammenfallen würde. Unabhängig davon welchen Abstand die Laserdioden 1.1, ..., 1.n und damit die Strahlachsen A₁, ..., Aₙ zueinander aufweisen werden die Achsstrahlen A₁, ..., Aₙ in den Brennpunkt F_{PS} und damit in den Mittelpunkt MP des Scanspiegels 2 reflektiert. Die parabolische Spiegelfläche PS kann eine toroidale parabolische Spiegelfläche sein, womit sich genaugenommen eine Brennlinie ergibt, die jedoch einen Punkt enthält, in dem alle Achsstrahlen A₁, ..., Aₙ zusammentreffen und der als Brennpunkt F_{PS} verstanden wird.

Die eine toroidale Austrittsfläche 5.2₁ ist in diesem Fall eine asphärische Zylinderfläche, wobei die Zylinderachsen der Eintrittsfläche 5.1 und der einen Austrittsfläche 5.2₁ senkrecht zueinander stehen.

Die Schale 6 und der optische Block 5 können einzeln hergestellt und miteinander, bevorzugt durch Kleben, verbunden sein. Vorteilhaft sind sie jedoch aus einem Stück monolithisch hergestellt.

Einen in den Figuren nicht dargestellten Sonderfall stellt eine Sendeeinrichtung mit nur einer Laserdiode 1.1 dar. Es bedarf hier keiner ersten Spiegelfläche 5.3₁, da die eine Strahlachse A₁ des nur einen Laserstrahls S₁ direkt auf den Mittelpunkt MP des Scanspiegels 2 gerichtet werden kann. Im Einkoppelbereich 4.1 wird dann der Laserstrahl S₁ nur über die Eintrittsfläche 5.1 und eine Austrittsfläche 5.2₁ geführt.

Alle Ausführungen einer erfindungsgemäßen Sendeeinrichtung haben den Vorteil, dass die gesamte Strahlformung zur Kollimation und die Strahlumlenkung der Laserdiodenstrahlen S₁, ..., Sₙ zum Scanspiegel 2 hin innerhalb des Abdeckelements 4 erfolgt, womit sie eine justagearme, kompakte Bauform aufweist.

### Bezugszeichenliste

- 1.1, ..., 1.n: Laserdiode
- 2: Scanspiegel
- 3: Gehäuse
- 4: Abdeckelement
- 4.1: Einkoppelbereich (des Abdeckelements 4)
- 4.2: Auskoppelbereich (des Abdeckelements 4)
- 5: optischer Block
- 5.1: Eintrittsfläche (des optischen Blocks 5)
- 5.2₁, ..., 5.2ₙ: Austrittsfläche (des optischen Blocks5)
- 5.3₁, ..., 5.3ₙ: erste Spiegelfläche (des optischen Blocks 5)
- 5.4: zweite Spiegelfläche (des optischen Blocks 5)
- 6: Schale
- S₁, ..., Sₙ: Laserstrahl
- A₁, ..., Aₙ: Strahlachse (des Laserstrahls S₁,..., Sₙ)
- fa: fast axis (der Laserdiode 1.1, ..., 1.n)
- sa: slow axis (der Laserdiode 1.1, ..., 1.n)
- MP: Mittelpunkt (des Scanspiegels 2)
- L: Lot
- HK: monozentrische Halbkugelschale
- PS: parabolische Spiegelfläche
- F_{PS}: Brennpunkt der parabolischen Spiegelfläche
- α₁, ..., αₙ: Auftreffwinkel

## Patentansprüche

1. Sendeeinrichtung, enthaltend
- mindestens eine Laserdiode (1.1, ..., 1.n), die jeweils einen Laserstrahl (S₁, ..., Sₙ) mit einer Strahlachse (A₁, ..., Aₙ) und unterschiedlichen Abstrahlwinkeln in einer fast axis (fa) und einer slow axis (sa) abstrahlt, wobei im Falle mehrerer Laserdioden (1.1, ..., 1.n) diese in Richtung ihrer slow axis (sa) nebeneinander, eine Reihe bildend angeordnet sind, und
- einen um seinen Mittelpunkt (MP) auslenkbaren Scanspiegel (2), der innerhalb eines Gehäuses (3) mit einem transparenten Abdeckelement (4) angeordnet ist, wobei der Scanspiegel in dem Gehäuse eingehaust und von dem Abdeckelement überdeckt und somit geschützt ist,
wobei die Strahlachse (A₁, ..., Aₙ) des wenigstens einen Laserstrahls (S₁, ..., Sₙ) von der mindestens einen Laserdiode (1.1, ..., 1.n) so auf das Abdeckelement (4) gerichtet ist, dass der wenigstens eine Laserstrahl (S₁, ..., Sₙ) nach Durchtritt innerhalb eines Einkoppelbereiches (4.1) des Abdeckelements (4) auf dem Mittelpunkt (MP) des Scanspiegels (2) auftrifft und nach Reflexion am Scanspiegel (2) das Abdeckelement (4) erneut, aber innerhalb eines Auskoppelbereiches (4.2), durchquert, **dadurch gekennzeichnet, dass**
• das Abdeckelement (4) in dem Einkoppelbereich (4.1) umfasst:
- eine toroidale Eintrittsfläche (5.1), die in Form einer Zylinderfläche zur Vorkollimierung des wenigstens einen Laserstrahls (S₁, ..., Sₙ) nur in Richtung der fast axis (fa), und
- wenigstens eine toroidale Austrittsfläche (5.2₁, ..., 5.2ₙ) zur separierten Vorkollimierung des wenigstens einen Laserstrahls (S₁, ..., Sₙ) in Richtung der slow axis (sa) und der fast axis (fa), oder
- wenigstens eine Austrittsfläche (5.2₁, ..., 5.2ₙ) in Form einer Zylinderfläche zur Vorkollimierung des wenigstens einen Laserstrahls (S₁,...,Sₙ) nur in Richtung der slow axis (sa),
- wobei der wenigstens eine Laserstrahl (S₁, ..., Sₙ) infolge der Vorkollimierung unter einem gleichen kleinen Konvergenzwinkel in Richtung der fast axis (fa) und der slow axis (sa) auf den Mittelpunkt (MP) des Scanspiegels (2) auftrifft und nach Durchtritt durch das Abdeckelement (4) innerhalb des Auskoppelbereiches (4.2), der eine negative Brechkraft hat, vollständig kollimiert ist, und
• das Abdeckelement (4) in dem Auskoppelbereich (4.2) umfasst:
- einen Ausschnitt einer um einen Krümmungsmittelpunkt (K) monozentrischen Halbkugelschale (HK), die so den Scanspiegel (2) überdeckend angeordnet ist, dass der Krümmungsmittelpunkt (K) der Halbkugelschale (HK) mit dem Mittelpunkt (MP) des Scanspiegels (2) zusammenfällt.

2. Sendeeinrichtung nach Anspruch 1, **dadurch gekennzeichnet, dass** das Abdeckelement (4) durch eine Schale (6) und einen in diesen integrierten oder angrenzenden optischen Block (5) gebildet ist, wobei an der Schale (6) der Ausschnitt der monozentrischen Halbkugelschale (HK) und an dem optischen Block (5)
- die toroidale Eintrittsfläche (5.1) in Form einer Zylinderfläche,
- die wenigstens eine toroidale Austrittsfläche (5.2₁, ..., 5.2ₙ) und
- wenigstens eine Spiegelfläche (5.3₁, ..., 5.3ₙ), die der mindestens einen Laserdiode (1.1, ..., 1.n) und der mindestens einen toroidalen Austrittsfläche (5.2₁, ..., 5.2ₙ) zugeordnet ist, um den wenigstens einen Laserstrahl (S₁, ..., Sₙ) auf den Mittelpunkt (MP) des Scanspiegels (2) zu richten,
ausgebildet sind.

3. Sendeeinrichtung nach Anspruch 1, **dadurch gekennzeichnet, dass** die Schale (6) einen Teil der monozentrischen Halbkugelschale (HK) darstellt.

4. Sendeeinrichtung nach einem der Ansprüche 1 bis 3, **dadurch gekennzeichnet, dass** die Sendeeinrichtung wenigstens zwei Laserdioden (1.1, ..., 1.n) enthält und zugeordnete erste Spiegelflächen (5.3₁, ..., 5.3ₙ) zueinander geneigte Planflächen sind, sodass die wenigstens zwei Laserstrahlen (S₁, ..., Sₙ) um unterschiedliche Winkel umgelenkt werden.

5. Sendeeinrichtung nach einem der Ansprüche 1 bis 3, **dadurch gekennzeichnet, dass** die Sendeeinrichtung wenigstens zwei Laserdioden (1.1, ..., 1.n) enthält und genau eine zugeordnete erste Spiegelfläche (5.3₁) vorhanden ist, die eine parabolische Fläche (PS) darstellt, so dass die wenigstens zwei Laserstrahlen (S₁, ..., Sₙ) um unterschiedliche Winkel umgelenkt werden.

6. Sendeeinrichtung nach Anspruch 4 oder 5, **dadurch gekennzeichnet, dass** der optische Block (5) eine zweite Spiegelfläche (5.4) aufweist, womit die wenigstens zwei Laserstrahlen (S₁, ..., Sₙ) gefaltet werden.

7. Sendeeinrichtung nach Anspruch 1, **dadurch gekennzeichnet, dass** das Abdeckelement (4) monolithisch hergestellt ist.

8. Sendeeinrichtung nach Anspruch 1, **dadurch gekennzeichnet, dass** genau eine Laserdiode (1.1) vorhanden ist und dieser einen Laserdiode (1.1) eine erste Spiegelfläche (5.3₁) zur Umlenkung des Laserstrahls (S₁) auf den Mittelpunkt (MP) des Scanspiegels (2) zugeordnet ist.

## Claims

1. A transmitter device, containing
- at least one laser diode (1.1, ..., 1.n), each of which emits a laser beam (S1, ..., Sₙ) with a beam axis (A₁, ..., Aₙ) and different radiation angles in a fast axis (fa) and a slow axis (sa), wherein in the case of a plurality of laser diodes (1.1, ..., 1.n) these are arranged next to one another in the direction of their slow axis (sa), forming a row, and
- a scanning mirror (2) which can be deflected about its centre (MP) and is arranged inside a housing (3) with a transparent covering element (4),
wherein the scanning mirror is enclosed in the housing and covered by the covering element and thus protected,
wherein the beam axis (A₁, ..., Aₙ) of the at least one laser beam (S₁, ..., Sₙ) is directed from the at least one laser diode (1.1, ..., 1.n) onto the covering element (4) in such a way that the at least one laser beam (S₁, ... , Sₙ) impinges on the centre (MP) of the scanning mirror (2) after passing within a coupling-in region (4.1) of the covering element (4) and, after reflection at the scanning mirror (2), passes through the covering element (4) again, but within a coupling-out region (4.2),
**characterised in that**
• the covering element (4) in the coupling-in region (4.1) comprises:
- a toroidal entrance surface (5.1), which is in the form of a cylindrical surface for pre-collimating the at least one laser beam (S₁, ..., Sₙ) only in the direction of the fast axis (fa), and
- at least one toroidal exit surface (5.2₁, ..., 5.2ₙ) for separate pre-collimation of the at least one laser beam (S₁, ..., Sₙ) in the direction of the slow axis (sa) and the fast axis (fa), or
- at least one exit surface (5.2₁, ..., 5.2ₙ) in the form of a cylindrical surface for pre-collimation of the at least one laser beam (S₁, ..., Sₙ) only in the direction of the slow axis (sa),
- wherein the at least one laser beam (S₁, ..., Sₙ) impinges on the centre (MP) of the scanning mirror (2) at an equally small convergence angle in the direction of the fast axis (fa) and the slow axis (sa) as a result of the pre-collimation and, after passing through the covering element (4), is completely collimated within the coupling-out region (4.2), which has a negative refractive power, and
• the covering element (4) in the coupling-out region (4.2) comprises:
- a section of a hemispherical shell (HK) which is monocentric about a centre of curvature (K) and is arranged to cover the scanning mirror (2) in such a way that the centre of curvature (K) of the hemispherical shell (HK) coincides with the centre (MP) of the scanning mirror (2).

2. The transmitter device according to claim 1, **characterised in that** the covering element (4) is formed by a shell (6) and an optical block (5) integrated into it or adjacent to it, wherein the section of the monocentric hemispherical shell (HK) is formed on the shell (6), and on the optical block (5)
- the toroidal entrance surface (5.1) in the form of a cylindrical surface,
- the at least one toroidal exit surface (5.2₁, ..., 5.2ₙ) and
- at least one mirror surface (5.3₁, ..., 5.3ₙ), which is associated with the at least one laser diode (1.1, ..., 1.n) and the at least one toroidal exit surface (5.2₁, ..., 5.2ₙ), in order to direct the at least one laser beam (S₁, ..., Sₙ) onto the centre (MP) of the scanning mirror (2),
are formed.

3. The transmitter device according to claim 1, **characterised in that** the shell (6) forms part of the monocentric hemispherical shell (HK).

4. The transmitter device according to any one of claims 1 to 3, **characterised in that** the transmitter device contains at least two laser diodes (1.1, ...; 1 .n) and associated first mirror surfaces (5.3₁, ..., 5.3ₙ) are planar surfaces inclined to one another, so that the at least two laser beams (S₁, ..., Sₙ) are deflected by different angles.

5. The transmitter device according to any one of claims 1 to 3, **characterised in that** the transmitter device contains at least two laser diodes (1.1, ..., 1.n) and exactly one associated first mirror surface (5.3₁) is present, which represents a parabolic surface (PS), so that the at least two laser beams (S₁, ..., Sₙ) are deflected by different angles.

6. The transmitter device according to claim 4 or 5, **characterised in that** the optical block (5) has a second mirror surface (5.4), by which the at least two laser beams (S₁, ..., Sₙ) are folded.

7. The transmitter device according to claim 1, **characterised in that** the covering element (4) is manufactured monolithically.

8. The transmitter device according to claim 1, **characterised in that** exactly one laser diode (1.1) is present and this one laser diode (1.1) is assigned a first mirror surface (5.3₁) for deflecting the laser beam (S₁) onto the centre (MP) of the scanning mirror (2).

## Revendications

1. Dispositif d'émission comprenant
- au moins une diode laser (1.1, ..., 1.n) qui émet respectivement un faisceau laser (S₁, ..., Sₙ) avec un axe de faisceau (A₁, ..., Aₙ) et des angles de rayonnement différents dans un axe rapide (fa) et un axe lent (sa), dans le cas de plusieurs diodes laser (1.1, ..., 1.n), celles-ci étant disposées les unes à côté des autres dans la direction de leur axe lent (sa), en formant une rangée, et
- un miroir de balayage (2) pouvant être dévié autour de son centre (MP) et disposé à l'intérieur d'un boîtier (3) avec un élément de recouvrement transparent (4),
le miroir de balayage étant encastré dans le boîtier et recouvert par l'élément de recouvrement et donc protégé,
l'axe de faisceau (A₁, ..., Aₙ) de l'au moins un faisceau laser (S₁, ..., Sₙ) étant dirigé par l'au moins une diode laser (1.1, ..., 1.n) sur l'élément de recouvrement (4) de telle sorte que l'au moins un faisceau laser (S₁, ..., Sₙ) rencontre le centre (MP) du miroir de balayage (2) après être traversé dans une zone de couplage (4.1) de l'élément de recouvrement (4) et, après réflexion sur le miroir de balayage (2), traverse à nouveau l'élément de recouvrement (4), mais dans une zone de découplage (4.2),
**caractérisé en ce que**
• l'élément de recouvrement (4) dans la zone de couplage (4.1) comporte:
- une surface d'entrée toroïdale (5.1), qui se présente sous la forme d'une surface cylindrique pour la précollimation dudit au moins un faisceau laser (S₁, ..., Sₙ) uniquement dans la direction de l'axe rapide (fa), et
- au moins une surface de sortie toroïdale (5.2₁, ..., 5.2ₙ) pour la précollimation séparée dudit au moins un faisceau laser (S₁, ..., Sₙ) dans la direction de l'axe lent (sa) et de l'axe rapide (fa), ou
- au moins une surface de sortie (5.2₁, ..., 5.2ₙ) sous la forme d'une surface cylindrique pour la précollimation dudit au moins un faisceau laser (S₁, ..., Sₙ) uniquement dans la direction de l'axe lent (sa),
- dans lequel ledit au moins un faisceau laser (S₁, ..., Sₙ), du fait de la précollimation, rencontre le centre (MP) du miroir de balayage (2) sous un même petit angle de convergence dans la direction de l'axe rapide (fa) et de l'axe lent (sa) et, après avoir traversé l'élément de recouvrement (4), est complètement collimaté à l'intérieur de la zone de découplage (4.2) qui a une puissance de réfraction négative, et
• l'élément de recouvrement (4) dans la zone de découplage (4.2) comporte:
- une section d'une coque hémisphérique (HK) monocentrique autour d'un centre de courbure (K), qui est disposée de manière à recouvrir le miroir de balayage (2) de telle sorte que le centre de courbure (K) de la coque hémisphérique (HK) coïncide avec le centre (MP) du miroir de balayage (2).

2. Dispositif d'émission selon la revendication 1, **caractérisé en ce que** l'élément de recouvrement (4) est formé par une coque (6) et un bloc optique (5) intégré ou adjacent à celle-ci, la découpe de la coque hémisphérique monocentrique (HK) étant formée sur la coque (6), et sur le bloc optique (5)
- la surface d'entrée toroïdale (5.1) sous la forme d'une surface cylindrique,
- l'au moins une surface de sortie toroïdale (5.2₁, ..., 5.2ₙ) et
- au moins une surface de miroir (5.3₁, ..., 5.3ₙ) associée à l'au moins une diode laser (1.1, ..., 1.n) et à l'au moins une surface de sortie toroïdale (5.2₁, ..., 5.2ₙ) pour diriger l'au moins un faisceau laser (S₁, ..., Sₙ) vers le centre (MP) du miroir de balayage (2),
sont formés.

3. Dispositif d'émission selon la revendication 1, **caractérisé en ce que** la coque (6) constitue une partie de la coque hémisphérique monocentrique (HK).

4. Dispositif d'émission selon l'une quelconque des revendications 1 à 3, **caractérisé en ce que** le dispositif d'émission comprend au moins deux diodes laser (1.1, ... ; 1.n) et des premières surfaces miroir associées (5.3₁, ..., 5.3ₙ) sont des surfaces planes inclinées les unes par rapport aux autres, de sorte que les au moins deux faisceaux laser (S₁, ..., Sₙ) sont déviés selon des angles différents.

5. Dispositif d'émission selon l'une quelconque des revendications 1 à 3, **caractérisé en ce que** le dispositif d'émission contient au moins deux diodes laser (1.1, ..., 1.n) et qu'il existe exactement une première surface de miroir (5.3₁) associée qui représente une surface parabolique (PS), de sorte que les au moins deux faisceaux laser (S₁, ..., Sₙ) sont déviés selon des angles différents.

6. Dispositif d'émission selon la revendication 4 ou 5, **caractérisé en ce que** le bloc optique (5) comporte une deuxième surface de miroir (5.4), avec laquelle les au moins deux faisceaux laser (S₁, ..., Sₙ) sont repliés.

7. Dispositif d'émission selon la revendication 1, **caractérisé en ce que** l'élément de recouvrement (4) est fabriqué de manière monolithique.

8. Dispositif d'émission selon la revendication 1, **caractérisé en ce qu'**il y a exactement une diode laser (1.1) et qu'à cette diode laser (1.1) est associée une première surface de miroir (5.3₁) pour dévier le faisceau laser (S₁) sur le centre (MP) du miroir de balayage (2).
